# FASCICULE DE BREVET EUROPEEN

(11) **EP 0 856 578 B1**
(45) Date de publication et mention de la délivrance du brevet: **06.11.2002**
(21) Numéro de dépôt: 98400171.9
(22) Date de dépôt: 28.01.1998
(51) Int. Cl.: C11D 7/50, B01D 12/00

(54) **Compositions de nettoyage ou de séchage à base de 1,1,1,2,3,4,4,5,5,5- décafluoropentane**
Reinigungs- oder Trocknungsmittel enthaltend 1,1,1,2,3,4,4,5,5,5-Decafluoropentan
Cleaning or drying compositions containing 1,1,1,2,3,4,4,5,5,6-decafluoropentane

(30) Priorité: 04.02.1997 FR 9701220
(43) Date de publication de la demande: 05.08.1998
(73) Titulaire: Atofina, 92800 Puteaux (FR)
(72) Inventeur: Michaud, Pascal, 95210 Saint-Gratien (FR); Martin, Jean-Jacques, 92270 Bois-Colombes (FR)

(56) Documents cités:
- US-A- 5 064 560
- US-A- 5 196 137
- DATABASE WPI Section Ch, Week 9437 Derwent Publications Ltd., London, GB; Class G04, AN 94-298877 XP002044060 & JP 06 226 005 A (MITSUI FLUOROCHEMICAL CO LTD) , 16 août 1994
- DATABASE WPI Section Ch, Week 9338 Derwent Publications Ltd., London, GB; Class E16, AN 93-299888 XP002044061 & JP 05 214 377 A (ASAHI CHEM IND CO LTD) , 24 août 1993
- PATENT ABSTRACTS OF JAPAN vol. 018, no. 040 (C-1155), 21 janvier 1994 & JP 05 263310 A (ASAHI CHEM IND CO LTD), 12 octobre 1993,
- DATABASE WPI Section Ch, Week 9328 Derwent Publications Ltd., London, GB; Class E19, AN 93-224471 XP002044062 & JP 05 148 498 A (DAIKIN KOGYO KK) , 15 juin 1993

## Description

La présente invention concerne le domaine des hydrocarbures fluorés et a plus particulièrement pour objet de nouvelles compositions utilisables pour nettoyer ou sécher des surfaces solides.

Le 1,1,2-trichloro-1,2,2-trifluoroéthane (connu dans le métier sous la désignation F113) a été largement utilisé dans l'industrie pour le nettoyage et le dégraissage de surfaces solides très diverses (pièces métalliques, verres, plastiques, composites). Outre son application en électronique au nettoyage des flux de soudure pour éliminer le flux décapant qui adhère aux circuits imprimés, on peut mentionner ses applications au dégraissage de pièces métalliques lourdes et au nettoyage de pièces mécaniques de haute qualité et de grande précision comme, par exemple, les gyroscopes et le matériel militaire, aérospatial ou médical. Dans ses diverses applications, le F113 est le plus souvent associé à d'autres solvants organiques (par exemple le méthanol), de préférence sous forme de mélanges azéotropiques ou quasi azéotropiques qui ne démixent pas et qui, employés au reflux, ont sensiblement la même composition dans la phase vapeur que dans la phase liquide.

Le F113 est également utilisé dans les opérations de séchage ou démouillage de surfaces au moyen d'agents tensio-actifs hydrophobes.

Cependant, l'emploi de compositions à base de F113 est maintenant interdit car le F113 fait partie des chlorofluorocarbures (CFC) suspectés d'attaquer ou de dégrader l'ozone stratosphérique.

Dans ces diverses applications, le F113 peut être remplacé par le 1,1-dichloro-1-fluoroéthane (connu sous la désignation F141b), mais l'utilisation de ce substitut est déjà réglementée car, bien que faible, son effet destructeur vis-à-vis de l'ozone n'est pas nul.

Les compositions azéotropiques décrites dans US-5.064.560 et US-5.196.137 sont basées sur le 1,1,1,2,3,4,4,5,5,5-décafluoropentane et le trans-1,2-dichloro-éthylène. Les compositions azéotropiques décrites dans JP-05/148498 sont constituées de 1,1,1,2,3,4,4,5,5,5-décafluoropentane et de méthanol.

JP-05/214377 propose des compositions azéotropiques avec du 2H,4H-perfluoropentane dans des solvants divers, par exemple du chlorure de méthylène.

Pour contribuer à résoudre ce problème, la présente invention propose de remplacer les compositions à base de F113 ou de F141b par des compositions azéotropiques ou quasi azéotropiques à base de 1,1,1,2,3,4,4,5,5,5-décafluoropentane. Ce composé (connu sous la désignation 43-10 mee) est totalement dépourvu d'effet destructeur vis-à-vis de l'ozone.

Les compositions à utiliser selon l'invention comprennent en poids 10 à 90 % de 43-10 mee, 10 à 90 % de chlorure de méthylène, et éventuellement 0 à 10 % de méthanol.

Une composition binaire particulièrement préférée selon l'invention est celle qui comprend en poids 40 à 60 % de 43-10 mee et 60 à 40 % de chlorure de méthylène. Dans ce domaine, il existe un azéotrope dont la température d'ébullition est de 34,2°C à la pression atmosphérique normale (1,013 bar).

Une composition ternaire selon l'invention comprend avantageusement, en poids, 30 à 69 % de 43-10 mee, 69 à 30 % de chlorure de méthylène et 1 à 10 % de méthanol. Est plus particulièrement préférée une composition ternaire contenant 39 à 59 % de 43-10 mee, 59 à 39 % de chlorure de méthylène et 2 à 8 % de méthanol. Dans ce domaine, il existe un azéotrope dont la température d'ébullition est de 33,2°C à la pression atmosphérique normale.

Les compositions selon l'invention ne présentent pas de point éclair dans les conditions standard de détermination (norme ASTM D 3828) et permettent donc de travailler en toute sécurité.

Comme dans les compositions de nettoyage connues à base de F113 ou de F141b, les compositions de nettoyage à base de 43-10 mee selon l'invention peuvent, si on le désire, être stabilisées contre l'hydrolyse et/ou les métaux légers et/ou les attaques radicalaires susceptibles de survenir dans les processus de nettoyage, en y ajoutant un stabilisant usuel tel que, par exemple, les nitroalcanes (nitrométhane, nitroéthane, nitropropane,...), les acétals (diméthoxyméthane) et les éthers (1,4-dioxane, 1,3-dioxolane), la proportion de stabilisant pouvant aller de 0,01 à 5 % par rapport au poids total de la composition. Comme stabilisant, on préfère utiliser la diméthoxyméthane dont le point d'ébullition est proche de celui des compositions azéotropiques selon l'invention ; de ce fait, ce stabilisant suit parfaitement le cycle du solvant, ce qui est particulièrement intéressant dans les applications de nettoyage.

Les compositions selon l'invention peuvent être utilisées dans les mêmes applications et selon les mêmes techniques que les compositions antérieures à base de F113 ou de F141b.

Le mélange azéotropique binaire est particulièrement bien approprié pour les opérations de séchage ou de démouillage de surfaces lorsque l'on utilise un agent tensio actif hydrophobe soluble dans la composition. Un tel type de composition comprenant de 0,05 à 8 % en poids d'agent tensio-actif permet l'élimination complète de l'eau des surfaces à traiter. Comme exemples d'agents tensio-actifs hydrophobes, on peut mentionner plus particulièrement les diamides de formule générale : 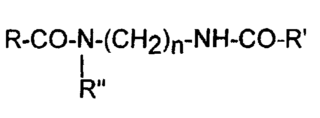 dans laquelle n est un nombre entier allant de 2 à 6 (de préférence 3) et les symboles R, R' et R", identiques ou différents, représentent chacun une chaîne aliphatique grasse contenant 12 à 30 atomes de carbone, de préférence 15 à 25.

Les exemples suivants illustrent l'invention sans la limiter.

### EXEMPLE 1:

Dans le bouilleur d'une colonne à distiller (30 plateaux), on introduit 100 g de Dans le bouilleur d'une colonne à distiller (30 plateaux), on introduit 100 g de 43-10 mee et 100 g de chlorure de méthylène CM2). Le mélange est ensuite mis à reflux total pendant une heure pour amener le système à l'équilibre.

Au palier de température, on recueille une fraction d'environ 50 g et on procède à son analyse par chromatographie en phase gazeuse.

L'examen des résultats, consignés dans le tableau suivant, indique la présence d'un azéotrope 43-10 mee/CM2 puisque la fraction recueillie a la même composition que le mélange initial. Il s'agit d'un azéotrope positif puisque son point d'ébullition est inférieur à celui du 43-10 mee (55°C) et à celui du CM2 (40°C).

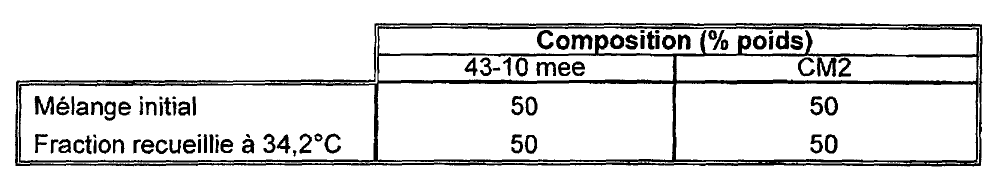

Cet azéotrope, employé pour le nettoyage de flux de soudure ou en dégraissage de pièces mécaniques, donne de bons résultats.

### EXEMPLE 2 : Composition stabilisée au diméthoxyméthane (méthylal)

Dans une petite cuve de nettoyage à ultrasons, on introduit 150g d'un mélange contenant en poids 49,7 % de 43-10 mee, 49,8 % de CM2 et 0,5 % de méthylal comme stabilisant. Après avoir mis le système à reflux pendant une heure, on prélève un aliquot de la phase vapeur. Son analyse, par chromatographie en phase gazeuse, montre la présence de méthylal, ce qui indique que le mélange est stabilisé dans la phase vapeur.

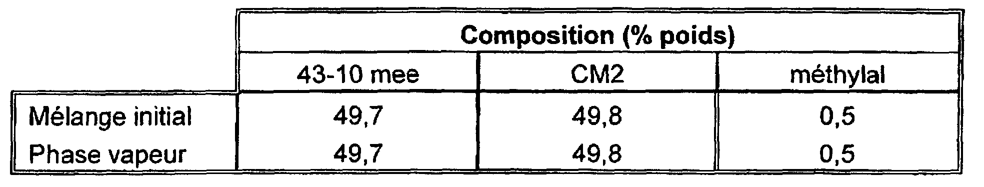

### EXEMPLE 3

### a) Mise en évidence d'un azéotrope43-10 mee/CM2/méthanol

Dans le bouilleur d'une colonne à distiller (30 plateaux), on introduit 100 g de 43-10 mee, 100 g de CM2 et 50 g de méthanol. Le mélange est ensuite mis à reflux total pendant une heure pour amener le système à l'équilibre. Au palier de température, on recueille une fraction d'environ 50g et on procède à son analyse par chromatographie en phase gazeuse.

L'examen des résultats consignés dans le tableau ci-dessous indique la présence d'une composition azéotropique.

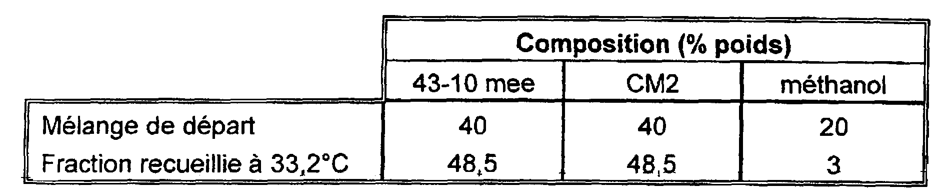

### b) Vérification de la composition azéotropique

Dans le bouilleur d'une colonne à distiller adiabatique (30 plateaux), on introduit 200 g d'un mélange comprenant 48,5 % de 43-10 mee, 48,5 % de CM2 et 3 % de méthanol. Le mélange est ensuite porté à reflux pendant une heure pour amener le système à l'équilibre, puis on soutire une fraction d'environ 50 g et on procède à son analyse par chromatographie en phase gazeuse.

Les résultats consignés dans le tableau suivant montrent la présence d'un azéotrope positif puisque son point d'ébullition est inférieur à ceux de ses trois composante.

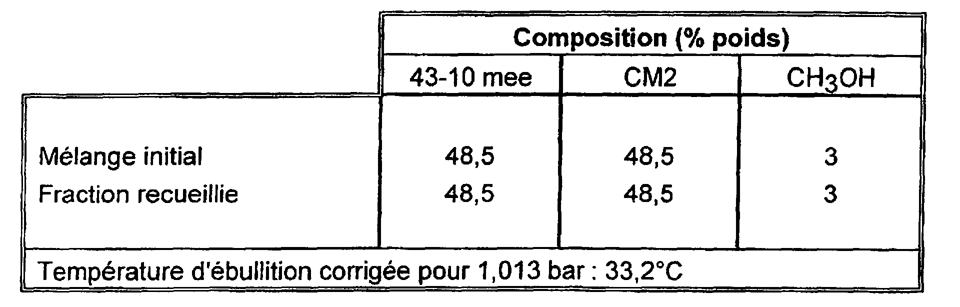

Cet azéotrope, employé pour le nettoyage de flux de soudure ou en dégraissage de pièces mécaniques, donne de bons résultats.

Comme dans l'exemple 2, la composition azéotropique ci-dessus peut être stabilisée avec 0,5 % de diméthoxyméthane.

### EXEMPLE 4 :Nettoyage de flux de soudure

Cinq circuits tests (modèle normalisé IPC-B-25) sont enduits de flux à base de colophane (flux R8F de la Société ALPHAMETAL) et recuits dans une étuve à 220°C pendant 30 secondes.

Ces circuits sont nettoyés a l'aide de la composition azéotropique de l'exemple 3, dans une petite machine à ultrasons pendant 3 minutes par immersion et 3 minutes en phase vapeur.

Le nettoyage est évalué selon la procédure normalisée IPC 2.3.26 à l'aide d'un conductimètre de précision. La valeur obtenue, 1,9 µg/cm² éq.NaCl, est très inférieure au seuil d'impuretés ioniques toléré par la profession (2,5 µg/cm² éq.NaCl).

### EXEMPLE 5 : Séchage

On prépare 250 ml d'une composition de séchage comprenant en poids 99,8 % du mélange binaire décrit dans l'exemple 1 et 0,2 % de N,N'-dioléoyl-N-oléylpropylènediamine.

Une grille inox de dimensions 5 x 3 cm est trempée dans de l'eau, puis est immergée pendant 30 secondes dans la composition de séchage en agitant manuellement.

L'eau résiduelle, dosée par la méthode de KARL FISCHER, indique l'élimination de l'eau à 100 %.

## Revendications

1. Composition azéotropique ou quasi azéotropique constituée de, en poids, 10 à 90% de 1,1,1,2,3,4,4,5,5,5-décafluoropentane, 10 à 90% de chlorure de méthylène, et 0 à 10 % de méthanol.

2. Composition selon la revendication 1 constituée par un mélange binaire de 40 à 60 % de 1,1,1,2,3,4,4,5,5,5-décafluoropentane et 60 à 40 % de chlorure de méthylène.

3. Composition selon la revendication 2 sous forme d'azéotrope bouillant à 34,2°C à la pression normale.

4. Composition selon la revendication 1 constituée par un mélange ternaire de 30 à 69 % (de préférence 39 à 59 %) de 1,1,1,2,3,4,4,5,5,5-décafluoropentane, 69 à 30 % (de préférence 59 à 39 %) de chlorure de méthylène et 1 à 10 % (de préférence 2 à 8 %) de méthanol.

5. Composition selon la revendication 4 sous forme d'azéotrope bouillant à 33,2°C à la pression normale.

6. Composition selon l'une des revendications 1 à 5 comprenant en outre au moins un stabilisant, de préférence le diméthoxyméthane.

7. Composition selon l'une des revendications 1 à 5 comprenant en outre au moins un agent tensio-actif hydrophobe.

8. Composition selon la revendication 7 dans laquelle la proportion pondérale d'agent tensio-actif est compris entre 0,05 et 8 %.

9. Application d'une composition selon l'une des revendications 1 à 6 au nettoyage des surfaces solides, en particulier au défluxage des circuits imprimés et au dégraissage des pièces mécaniques.

10. Application d'une composition selon la revendication 7 ou 8 au séchage ou démouillage de surfaces solides.

## Claims

1. Azeotropic or virtually azeotropic composition consisting of, on a weight basis, 10 to 90% of 1,1,1,2,3,4,4,5,5,5-decafluoropentane, 10 to 90% of methylene chloride and 0 to 10% of methanol.

2. Composition according to Claim 1, consisting of a binary mixture of 40 to 60% of 1,1,1,2,3,4,4,5,5,5-decafluoropentane and 60 to 40% of methylene chloride.

3. Composition according to Claim 2, in the form of an azeotrope boiling at 34.2°C at normal pressure.

4. Composition according to Claim 1, consisting of a ternary mixture of 30 to 69% (preferably 39 to 59%) of 1,1,1,2,3,4,4,5,5,5-decafluoropentane, 69 to 30% (preferably 59 to 39%) of methylene chloride and 1 to 10% (preferably 2 to 8%) of methanol.

5. Composition according to Claim 4, in the form of an azeotrope boiling at 33.2°C at normal pressure.

6. Composition according to one of Claims 1 to 5, also comprising at least one stabilizer, preferably dimethoxymethane.

7. Composition according to one of Claims 1 to 5, also comprising at least one hydrophobic surfactant.

8. Composition according to Claim 7, in which the weight proportion of surfactant is between 0.05 and 8%.

9. Application of a composition according to one of Claims 1 to 6 to the cleaning of solid surfaces, in particular to the defluxing of printed circuits and to the degreasing of mechanical components.

10. Application of a composition according to Claim 7 or 8 to the drying or dewetting of solid surfaces.

## Patentansprüche

1. Azeotrope oder quasi-azeotrope Zusammensetzung, bestehend aus 10 bis 90 Gew.-% 1,1,1,2,3,4,4,5,5,5-Decafluorpentan, 10 bis 90 Gew.-% Methylenchlorid und 0 bis 10 Gew.-% Methanol.

2. Zusammensetzung nach Anspruch 1, bestehend aus einer binären Mischung von 40 bis 60 % 1,1,1,2,3,4,4,5,5,5-Decafluorpentan und 60 bis 40 % Methylenchlorid.

3. Zusammensetzung nach Anspruch 2 in Form eines Azeotrops, das unter Normaldruck bei 34,2 °C siedet.

4. Zusammensetzung nach Anspruch 1, bestehend aus einer ternären Mischung von 30 bis 69 % (vorzugsweise 39 bis 59 %) 1,1,1,2,3,4,4,5,5,5-Decafluorpentan, 69 bis 30 % (vorzugsweise 59 bis 39 %) Methylenchlorid und 1 bis 10 % (vorzugsweise 2 bis 8 %) Methanol.

5. Zusammensetzung nach Anspruch 4 in Form eines Azeotrops, das unter Normaldruck bei 33,2 °C siedet.

6. Zusammensetzung nach einem der Ansprüche 1 bis 5, enthaltend außerdem mindestens einen Stabilisator, vorzugsweise Dimethoxymethan.

7. Zusammensetzung nach einem der Ansprüche 1 bis 5, enthaltend außerdem mindestens ein hydrophobes Tensid.

8. Zusammensetzung nach Anspruch 7, wobei der gewichtbezogene Anteil des Tensids in der Zusammensetzung zwischen 0,05 und 8 % liegt.

9. Verwendung einer Zusammensetzung gemäß einem der Ansprüche 1 bis 6 zur Reinigung von festen Oberflächen, insbesondere zur Flußmittelentfernung bei gedruckten Schaltungen und zur Entfettung von mechanischen Teilen.

10. Verwendung einer Zusammensetzung gemäß Anspruch 7 oder 8 zur Trocknung oder zur Aufhebung der Benetzbarkeit von festen Oberflächen.
